(19) 【Europäisches Patentamt / European Patent Office / Office européen des brevets】

(11) **EP 4 696 744 A1**

(12) **EUROPEAN PATENT APPLICATION**
published in accordance with Art. 153(4) EPC

(43) Date of publication:
**18.02.2026 Bulletin 2026/08**

(21) Application number: **24897881.9**

(22) Date of filing: **21.10.2024**

(51) International Patent Classification (IPC):
*C08L 63/00* (2006.01)   *C08G 59/40* (2006.01)
*C08G 59/62* (2006.01)   *C08L 35/06* (2006.01)
*C08K 3/36* (2006.01)   *C08J 5/18* (2006.01)
*H05K 1/03* (2006.01)

(52) Cooperative Patent Classification (CPC):
C08G 59/40; C08G 59/62; C08J 5/18; C08K 3/36;
C08L 35/06; C08L 63/00; H05K 1/03

(86) International application number:
**PCT/KR2024/015938**

(87) International publication number:
**WO 2025/116283 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 30.11.2023 KR 20230171426
18.10.2024 KR 20240143082

(71) Applicant: **LG Chem, Ltd.**
**Seoul 07336 (KR)**

(72) Inventors:
• **PARK, Jun Wuk**
**Daejeon 34122 (KR)**
• **KIM, Bokyung**
**Daejeon 34122 (KR)**

• **KIM, Tae Soon**
**Daejeon 34122 (KR)**
• **PARK, Daseul**
**Daejeon 34122 (KR)**
• **YOON, Youngsik**
**Daejeon 34122 (KR)**
• **LEE, Jonghwa**
**Daejeon 34122 (KR)**
• **CHOI, Byung Ju**
**Daejeon 34122 (KR)**
• **HWANG, Seongmin**
**Daejeon 34122 (KR)**

(74) Representative: **Hoffmann Eitle**
**Patent- und Rechtsanwälte PartmbB**
**Arabellastraße 30**
**81925 München (DE)**

(54) **THERMOSETTING RESIN COMPOSITION, AND INSULATING FILM AND PRINTED CIRCUIT BOARD COMPRISING SAME**

(57)    The present specification relates to a thermosetting resin composition including an epoxy resin as a curable resin, a cyanate ester resin and a phenol resin as curing agents, and a silica having an average particle diameter of 0.1 μm or more and less than 0.2 μm as an inorganic filler, and an insulating film and a printed circuit board including the same. The thermosetting resin composition according to the exemplary embodiments may ensure excellent curing properties and excellent high temperature reliability.

EP 4 696 744 A1

**Description**

[Technical Field]

The present specification relates to a thermosetting resin composition, and an insulating film and a printed circuit board including the same.

This application claims priority to and the benefit of Korean Patent Application Nos. 10-2023-0171426 and 10-2024-0143082 filed in the Korean Intellectual Property Office on November 30, 2023 and October 18, 2024, respectively.

[Background Art]

A printed circuit board (PCB) means, as a support for electronic components, a board in which the electronic components are fixed to the surface of a printed wiring board and the components are connected with copper wiring to form an electronic circuit.

Generally, the printed circuit board is based on the formation of multiple layers by insulating connection between copper wirings. In order to increase the reliability of the board, methods of improving the adhesive strength between an insulating layer and a copper foil layer, such as methods of including in the insulating layer a component that has a high bonding strength with Cu, or of forming surface roughness on the surface of the insulating layer to increase the surface area of the interface have been proposed.

As a method for manufacturing a multi-layer printed circuit board, a method has been publicly known in which a prepreg sheet is used to stack layers on an inner layer circuit board on which a copper foil circuit is formed, and interlayer connection is performed by through-holes, but this method requires large-scale installations, is highly costly and time-consuming, and has problems in that it is difficult to form fine patterns.

As a method of solving the above problems, a method for manufacturing a multi-layer printed circuit board in combination with a build-up method has been recently proposed. This is a technology that involves alternately stacking organic insulating layers (or insulating films) on the conductor layer of a circuit board.

Generally, the process of manufacturing a build-up type multi-layer printed circuit board is carried out in the following order: vacuum laminating a build-up insulating film onto an inner layer circuit; precuring the insulating film; drilling the insulating film; desmearing the insulting film; electroless plating the insulating film; electrolytic plating the insulating film; postcuring the insulating film; and forming an outer layer circuit.

The desmearing of the insulating film is an essential process to remove smears (residues derived from the resin components included in the insulating film) from the insulating film using an acidic solution, and a certain level of roughness is formed by eroding a certain portion of surface of the insulating film through chemical treatment. The roughness formed on the surface of the insulating film in this manner serves to increase the adhesion with a copper foil layer in the future.

Although, as a resin composition for the build-up insulating film, a composition in which an epoxy resin and a phenolic curing agent are filled with silica particles as an inorganic filler was used in initial products, products using cyanate ester-based curing agents in epoxy resins tend to be developed as a need for low dielectric properties and low CTE increases.

However, although the cured product of an epoxy resin and a cyanate ester resin has advantages such as low CTE and low Df, the cured product is easily hydrolyzed by residual moisture at high temperatures, and thus, may cause a problem of defects due to deterioration of durability and/or reliability in a high temperature environment, such as gas generation, blister production, and deterioration of mechanical properties.

When an inorganic filler having a large particle diameter is used, there is an advantage in that the adhesion to a copper foil layer is improved because it is easy to control the surface roughness formed during the desmearing of the insulating film, but there is a problem in that it is difficult to process micro-sized via holes due to the detachment of inorganic filler particles during laser drilling. When an inorganic filler having a small particle diameter of $0.1 \mu m$ or more and less than $0.2 \mu m$ is used to ameliorate the problem, the surface roughness formed after the desmear process is so low that the interlocking effect at the interface with a copper foil layer decreases, and as a result, the above-mentioned reliability degradation problem may become even more serious.

Accordingly, there is a need for the development of a substance that secures advantages such as low CTE and low Df while improving durability and/or reliability in a high temperature environment.

[Detailed Description of the Invention]

[Technical Problem]

The present specification relates to a thermosetting resin composition for solving the above problems, and an insulating film and a printed circuit board including the same.

[Technical Solution]

The present inventors have confirmed that when an epoxy resin is used as a curable resin, a cyanate ester resin and a phenol resin as curing agents, and a styrene-maleic anhydride copolymer are used, and a silica having an average particle diameter of 0.1 μm or more and less than 0.2 μm is used as an inorganic filler, durability and/or reliability simultaneously are/is ensured to a certain level or more in a high temperature environment while securing the advantages such as low CTE and low Df of the existing cured product of an epoxy resin and a cyanate ester resin.

Accordingly, in order to solve the problems in the related art, the exemplary embodiments of the present specification are as follows.

An exemplary embodiment of the present specification provides a thermosetting resin composition including a curable resin, a curing agent, a styrene-maleic anhydride copolymer (SMA), and an inorganic filler, in which the curable resin includes an epoxy resin, the curing agent includes a cyanate ester resin and a phenol resin, and the inorganic filler includes a silica having an average particle diameter of 0.1 μm or more and less than 0.2 μm.

Another exemplary embodiment of the present specification provides an insulating film including the above-described thermosetting resin composition and a cured product thereof.

Still another exemplary embodiment of the present specification provides a printed circuit board including the above-described insulating film.

[Advantageous Effects]

Since the thermosetting resin composition according to the present specification has excellent cured physical properties such as a low coefficient of thermal expansion (CTE), a low dielectric constant (Df) or dissipation factor (Df), and a high glass transition temperature (Tg), warpage can be reduced when an insulating film using the composition is used for a printed circuit board.

Further, since the thermosetting resin composition according to the present specification has excellent durability at high temperatures (about 200°C or higher), the reliability can be improved when an insulating film using the composition is used for a printed circuit board in the future.

In addition, since the thermosetting resin composition according to the present specification has excellent copper foil adhesion, it is possible to provide the advantage of not causing defects such as blisters when an insulating film using the composition is used for a printed circuit board in the future.

[Best Mode]

Hereinafter, the present specification will be described in more detail.

**<Thermosetting Resin Composition>**

Hereinafter, a thermosetting resin composition according to an exemplary embodiment of the present specification will be described.

As described above, the thermosetting resin composition according to an exemplary embodiment of the present specification is characterized by including an epoxy resin as a curable resin, a cyanate ester resin and a phenol resin as curing agents, and a silica having an average particle diameter of 0.1 μm or more and less than 0.2 μm as an inorganic filler.

When the composition is as described above, it is possible to simultaneously have excellent cured physical properties (low coefficient of thermal expansion, low dielectric constant, and high glass transition temperature) and excellent high temperature durability and reliability.

According to another exemplary embodiment of the present specification, the silica may have an average particle diameter of less than 0.2 μm, 0.19 μm or less, or 0.18 μm or less, and may have an average particle diameter of 0.1 μm or more.

When the silica has an average particle size within the above range, it is possible to form a certain level of surface roughness even after desmearing, which is recently required for a printed circuit board for a micropattern. When a silica having an average particle diameter of at least 0.2 μm is used, the surface roughness formed may be too high due to desmearing, and it may be difficult to process via holes with a desired size due to the detachment of large silica particles during laser drilling. Further, when a silica having an average particle diameter of less than 0.1 μm is used, the surface roughness formed may be too low due to desmearing, or the dielectric loss may be high, or the copper foil adhesion may deteriorate. In addition, when a silica having an average particle diameter of 0.01 μm or less is used, film processing itself may become difficult due to the problem of increased solution viscosity.

In the present specification, the epoxy resin is not particularly limited to those publicly known in the art, but examples thereof include a naphthalene type, a phenol type, an olefin type, a diglycidyl ether of bisphenol A DGEBA type, diglycidyl ether of bisphenol F (DGEBF) type, a phenol novolac type, a cresol novolac type, a bisphenol type, a rubber-modified type, and the like, and the above-exemplified types of epoxy resins may be used alone or in mixture of two or more thereof.

In the present specification, the cyanate ester resin is not particularly limited to those publicly known in the art, but examples thereof include a novolac type, a dicyclopentadiene type, a bisphenol type (a bisphenol A type, a bisphenol F type, a bisphenol S type, and the like), a prepolymer in which a portion of the cyanate ester resins of the above-exemplified types is converted to triazine, and the like, and the above-exemplified types of cyanate ester resins may be used alone or in mixture of two or more thereof.

In the present specification, the styrene-maleic anhydride copolymer (SMA) is not particularly limited to those publicly known in the art, but examples thereof include NST-438, SMAEF30, SMAEF40, SMAEF60, SMAEF80, SMA1000, SMA2000, and the like, and the above-exemplified SMAs may be used alone or in mixture of two or more thereof.

According to an exemplary embodiment of the present specification, the styrene-maleic anhydride copolymer may include 10% or more and 40% or less of maleic anhydride (based on the entire styrene-maleic anhydride copolymer).

When the content of maleic anhydride in the styrene-maleic anhydride copolymer is less than 10%, the effect of improving high temperature durability by the addition may be minimal, and when the content of maleic anhydride exceeds 40%, the mechanical properties of the final cured product may deteriorate.

According to an exemplary embodiment of the present specification, the content of the styrene-maleic anhydride copolymer may be 5 parts by weight or more and less than 40 parts by weight with respect to 100 parts by weight of the cyanate ester resin.

When the content of the styrene-maleic anhydride copolymer is less than 5 parts by weight with respect to 100 parts by weight of the cyanate ester resin, the effect of improving high temperature durability may be minimal, and when the content exceeds 40 parts by weight, the mechanical properties of the final cured product may deteriorate.

According to an exemplary embodiment of the present specification, the curing agent further includes a phenol resin, and the weight ratio between the cyanate ester resin and the phenol resin may be 95:5 to 40:60. Preferably, the weight ratio between the cyanate ester resin and the phenol resin may be 90:10 to 60:40, or 85:25 to 70:30.

When the cyanate ester resin, which corresponds to a curing agent, is mixed with a phenol resin in the above weight ratio range, the curing speed of the cyanate ester resin is accelerated, and a cured product having various mechanical properties may be obtained depending on the type and content of the phenol resin used. In addition, as described above in the desirable range, when the content of the phenol resin is less than the content of the cyanate ester resin, fewer hydrophilic OH groups may be formed after curing with the epoxy, so that the desired low Df characteristics may be more easily achieved.

According to an exemplary embodiment of the present specification, the phenol resin may include a compound including a phenol backbone, a naphthol backbone, or a novolac backbone.

According to an exemplary embodiment of the present specification, the phenol resin may be a compound including a novolac backbone.

When the phenol resin includes the above-described backbone, the heat resistance, water resistance, and the like may be improved.

According to an exemplary embodiment of the present specification, the weight ratio between the epoxy resin and the cyanate ester resin may be 60:40 to 20:80.

When the weight ratio between the epoxy resin and the cyanate ester resin is within the above range, no unreacted epoxy resin remains after curing, so that further improvement in dielectric characteristics and mechanical properties may be expected, and furthermore, the weight ratio is helpful in improving high temperature durability. Further, excessive self-crosslinking reaction of the cyanate ester resin is controlled, so that it is possible to prevent brittle fracture, in which the film easily breaks after curing.

According to an exemplary embodiment of the present specification, the thermosetting resin composition further includes an additive, and the additive may be selected from the group consisting of a curing accelerator, a leveling agent, a wetting agent, an antistatic agent, a thermoplastic polymer resin, and an antioxidant.

In the present specification, the curing accelerator is a substance for accelerating the curing reaction of the thermosetting resin composition together with the curing agent, and is not particularly limited to those publicly known in the art, examples thereof include an imidazole-based compound, an amine-based compound, an organic phosphine compound, and a metal-based compound, and the curing accelerators exemplified above may be used alone or in mixture of two or more thereof.

The imidazole-based compound may include 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanurate adducts, 2-phenylimidazole isocyanurate adducts, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzyl imidazolium chloride, 2-methylimidazoline, 2-phenylimidazoline, and the like.

Examples of the amine-based compound include triethylamine, tributylamine, 4-dimethylaminopyridine, benzyldimethylamine, 2,4,6-tris(dimethylaminomethyl)phenol, 1,8-diazabicyclo(5,4,0)-undecene, and the like.

Examples of the metal-based compound include an organometallic complex or organometallic salt of a metal such as cobalt, copper, zinc, iron, nickel, manganese, and tin. Specific examples of the organometallic complex include cobalt(II) acetylacetonate, cobalt(III) acetylacetonate, copper(II) acetylacetonate, zinc(II) acetylacetonate, iron(III) acetylacetonate, nickel(II) acetylacetonate, manganese(II) acetylacetonate, and the like. In addition, the organometallic salt may include zinc octylate, tin octylate, zinc naphthenate, cobalt naphthenate, tin stearate, zinc stearate, and the like.

Furthermore, assuming that a non-volatile content in the thermosetting resin composition is 100% by mass, the curing accelerator may be used in an amount within a range of 0.01% to 5%.

In the present specification, the leveling agent and wetting agent are substances that improve coating processability and coating appearance by controlling the surface tension, flowability, spreadability, and the like of the curable resin composition, and are not particularly limited to those publicly known in the art.

In the present specification, the antistatic agent is a substance that imparts an antistatic effect, and is not particularly limited to those publicly known in the art. In some cases, the antistatic agents may be used alone or in mixture of two or more thereof.

In the present specification, the thermoplastic polymer resin may be included in order to improve the mechanical strength, film-forming ability, and the like of the curable resin composition, and is not particularly limited to those publicly known in the art, and examples thereof include a phenoxy resin, a polyvinyl acetal resin, a polyvinyl butyral resin, a polyimide resin, a polyamideimide resin, a polyetherimide resin, a polysulfone resin, a polyethersulfone resin, a polyphenylene ether resin, a polycarbonate resin, a polyetheretherketone resin, a polyester resin, and the like. In some cases, the thermoplastic polymer resins may be used alone or in mixture of two or more thereof. It is preferred that the thermoplastic resin includes a phenoxy resin. The weight average molecular weight of the thermoplastic resin may be 5,000 g/mol to 200,000 g/mol, but is not limited thereto.

In the present specification, the antioxidant is a substance that improves thermal stability, and is not particularly limited to those publicly known in the art. In some cases, the antioxidants may be used alone or in mixture of two or more thereof.

In an exemplary embodiment of the present specification, the thermosetting resin composition may include a solvent.

In the present specification, when the thermosetting resin composition includes a solvent, the solvent may be applied without any particular limitation as long as it is publicly known to enable the formation of a thermosetting resin composition in the art to which the present invention pertains. As a non-limiting example, the solvent may be one or more compounds selected from the group consisting of esters, ethers, ketones, aromatic hydrocarbons, and sulfoxides.

The ester solvent may be ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, gamma-butyrolactone, epsilon-caprolactone, delta-valerolactone, alkyl oxyacetate (for example: methyl oxyacetate, ethyl oxyacetate, butyl oxyacetate (for example, methyl methoxyacetate, ethyl methoxyacetate, butyl methoxyacetate, methyl ethoxyacetate, ethyl ethoxyacetate, and the like)), 3-oxypropionic acid alkyl esters (for example: methyl 3-oxypropionate, ethyl 3-oxypropionate, and the like (for example, methyl 3-methoxypropionate, ethyl 3-methoxypropionate, methyl 3-ethoxypropionate, ethyl 3-ethoxypropionate, and the like)), 2-oxypropionic acid alkyl esters (for example: methyl 2-oxypropionate, ethyl 2-oxypropionate, propyl 2-oxypropionate, and the like (for example, methyl 2-methoxypropionate, ethyl 2-methoxypropionate, propyl 2-methoxypropionate, methyl 2-ethoxypropionate, ethyl 2-ethoxypropionate)), methyl 2-oxy-2-methylpropionate and ethyl 2-oxy-2-methylpropionate (for example, methyl 2-methoxy-2-methylpropionate, ethyl 2-ethoxy-2-methylpropionate, and the like), methyl pyruvate, ethyl pyruvate, propyl pyruvate, methyl acetoacetate, ethyl acetoacetate, methyl 2-oxobutanoate, ethyl 2-oxobutanoate, or the like.

The ether solvent may be diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate, or the like.

The ketone solvent may be methyl ethyl ketone (MEK), cyclohexanone, cyclopentanone, 2-heptanone, 3-heptanone, N-methyl-2-pyrrolidone, or the like.

The aromatic hydrocarbon solvent may be toluene, xylene, anisole, limonene, or the like.

The sulfoxide solvent may be dimethyl sulfoxide or the like.

**<Insulating film>**

Hereinafter, an insulating film according to an exemplary embodiment of the present specification will be described.

An exemplary embodiment of the present specification provides an insulating film including the above-described thermosetting resin composition, specifically a build-up insulating film.

The insulating film according to the present specification may be processed on a circuit in the future in the order of vacuum lamination, precure, drilling, desmear, electroless plating, electrolytic plating, postcure, and outer layer circuit formation to manufacture a printed circuit board.

In the present specification, the insulating film may have the following curing properties through thermal curing (for example, thermal curing at a temperature of 190°C to 200°C for 90 minutes or more).

In an exemplary embodiment of the present specification, the insulating film in a cured state under a condition of 10 GHz may have a coefficient of thermal expansion (CTE) value of 45 ppm/°C or less.

In another exemplary embodiment of the present specification, the coefficient of thermal expansion (for the insulating film) measured in a cured state may be 40 ppm/°C or less, 35 ppm/°C or less, or 30 ppm/°C or less, and may be 15 ppm/°C or more.

When the coefficient of thermal expansion satisfies the above range, the difference in coefficient of thermal expansion with a copper foil is small, so that there is an advantage in that the amount of warpage that occurs after stacking with the copper foil layer is small.

Specifically, the coefficient of thermal expansion may be measured in a temperature range of 25°C to 120°C using a thermometer analyzer (TMA) after the insulating film is heat cured at a temperature of 190°C for 90 minutes.

In an exemplary embodiment of the present specification, under a condition of 10 GHz, the insulating film in a cured state may have a dielectric constant (Dk) value of 3.5 or less and a dissipation factor (Df) value of 0.015 or less.

In another exemplary embodiment of the present specification, the Dk value of the insulating film measured in a cured state may be 3.4 or less, 3.3 or less, or 3.2 or less, and may be 2.4 or more.

In still another exemplary embodiment of the present specification, the Df value of the insulating film may be 0.0145 or less, or 0.014 or less, and may be 0 or more.

When the dielectric constant and dissipation factor satisfy the above ranges, it is advantageous for dealing with micro wiring and high-speed transmission required for high integration and high densification of semiconductor chips.

According to an exemplary embodiment of the present specification, the difference in adhesion of the insulating film to a copper foil may satisfy the following Equation 1.

$$A2/A1 > 0.75 - \text{Equation 1}$$

In Equation 1,

A1 is the initial copper foil adhesion (gf/cm) measured after copper plating on at least one surface of the insulating film, and A2 is the final copper foil adhesion (gf/cm) measured after a hot air reflow test (performed 10 times at a maximum temperature of 260°C) on the insulating film.

When the above range is satisfied, the insulating film may be evaluated for a high temperature durability to be high.

In an exemplary embodiment of the present specification, the average value of the arithmetic mean roughness (Ra) measured on the surface of the desmeared insulating film using an optical profiler (Nanoview 3D surface profiler NV-2700, Nanosystem) may be 80 nm or more, 100 nm or more, or 120 nm or more, and may be 500 nm or less, 400 nm or less, or 300 nm or less.

When the surface roughness of the insulating film after desmear treatment is less than 80 nm, the interlocking effect at the interface with a copper foil decreases, and reliability deterioration problems may additionally occur, and when the surface roughness formed after desmear treatment exceeds 500 nm, the copper foil adhesion is excellent, but when flash etching is performed after electroplating, there is a problem in that the plating removal time is prolonged and the wiring shape becomes thinner, and it is also difficult to apply the insulating film to a micro line width of less than 10 μm, which has been recently required.

**<Printed circuit board>**

Hereinafter, a printed circuit board according to an exemplary embodiment of the present specification will be described. Since the printed circuit board includes an insulating film formed of the above-described thermosetting resin composition, the above-described contents on the thermosetting resin composition may be applied.

[Mode for Invention]

Hereinafter, the present specification will be described in detail with reference to Examples for specifically describing the present specification. However, the Examples according to the present specification may be modified in various forms, and it is not interpreted that the scope of the present specification is limited to the Examples described below. The Examples of the present specification are provided to more completely describe the present specification to a person with ordinary skill in the art.

**<Examples>**

Example 1: \Preparation of Thermosetting Resin Composition 1

70 parts by weight of a bisphenol-based epoxy resin (YD-128, KUKDO CHEMICAL CO., LTD.) and 30 parts by weight of a phenol novolac type epoxy resin (YDPN-639, KUKDO CHEMICAL CO., LTD.) as epoxy resins which are curable resins, 112 parts by weight of a dicyclopentadiene bisphenol-based cyanate ester resin (a MEK solution containing 75% of non-volatile components, C03CS, TECHIA), 24 parts by weight of a biphenyl-based phenol resin (GPH-65, Nippon Kayaku Co., Ltd.), 14 parts by weight of a styrene-maleic anhydride copolymer (a MEK solution containing 60% of non-volatile components, NST-438, Nanokor Co., Ltd.), 385 parts by weight of a silica slurry having an average particle diameter of 0.18 $\mu$m as an inorganic filler (a MEK solution containing 60% non-volatile components, K180SX-CM3, ADMATECHS), 15 parts by weight of a phenoxy resin (YP-50, KUKDO CHEMICAL CO., LTD.) as an additive (a thermoplastic polymer resin), and 126 parts by weight of methyl ethyl ketone (MEK) as a solvent were mixed and then stirred at 250 rpm for 3 hours using a mechanical stirrer.

Thereafter, 1.0 part by weight of an imidazole-based curing accelerator (2PHZ-PW, Shikoku Chemicals) and 0.05 parts by weight of an inorganic metal-based curing accelerator cobalt(II) acetylacetonate (TCI) were added thereto, and Thermosetting Resin Composition 1 was prepared by uniformly dispersing the resulting mixture using a high-speed rotating mixer.

**Examples 2 to 5: Preparation of Thermosetting Resin Compositions 2 to 5**

Thermosetting Resin Compositions 2 to 5 were prepared in the same manner as in Example 1, except that during the preparation of the thermosetting resin composition, the type and content of each component (based on 100 parts by weight of a curable resin (an epoxy resin)) were changed as shown in the following Table 1.

**Example 6: Preparation of Thermosetting Resin Composition 6**

Thermosetting Resin Composition 6 was prepared in the same manner as in Example 1, except that during the preparation of the thermosetting resin composition, the type and content of each component (based on 100 parts by weight of a curable resin (an epoxy resin)) were changed and the inorganic filler was changed to 385 parts by weight of a silica slurry (a MEK solution containing 60% of non-volatile components, SC2050-MB, ADMATECHS) having an average particle diameter of 0.1 $\mu$m as shown in the following Table 1.

**Comparative Example 1: Preparation of Thermosetting Resin Composition A**

Thermosetting Resin Composition A was prepared in the same manner as in Example 1, except that the styrene-maleic anhydride resin was not added and the content of the phenoxy resin (YP-50, KUKDO CHEMICAL CO., LTD.) was changed to 23 parts by weight as shown in the following Table 1.

**Comparative Example 2: Preparation of Thermosetting Resin Composition B**

Thermosetting Resin Composition B was prepared in the same manner as in Example 1, except that the inorganic filler was changed to 330 parts by weight of a silica slurry (a MEK solution containing 70% of non-volatile components, SC2050-MB, ADMATECHS) having an average particle diameter of 0.5 $\mu$m and the solvent was changed to 181 parts by weight of methyl ethyl ketone (MEK) as shown in the following Table 1.

**Comparative Example 3: Preparation of Thermosetting Resin Composition C**

Thermosetting Resin Composition C was prepared in the same manner as in Example 1, except that the inorganic filler was changed to 462 parts by weight of a silica slurry (a MEK solution containing 50% of non-volatile components, Y50SZ-AM1, ADMATECHS) having an average particle diameter of 0.05 $\mu$m and the solvent was changed to 49 parts by weight of methyl ethyl ketone (MEK) as shown in the following Table 1.

**Comparative Example 4: Preparation of Thermosetting Resin Composition D**

Thermosetting Resin Composition D was prepared in the same manner as in Example 1, except that a cyanate ester resin was not added, the content of the phenol resin (GPH-65, Nippon Kayaku Co., Ltd.) was changed to 108 parts by weight, and the content of the solvent was changed to 154 parts by weight of methyl ethyl ketone (MEK) as shown in the following Table 1.

**Comparative Example 5: Preparation of Thermosetting Resin Composition E**

Thermosetting Resin Composition E was prepared in the same manner as in Example 1, except that the phenol resin was not added, the content of the cyanate ester resin (a MEK solution containing 75% of non-volatile components, CO3CS, TECHIA) was changed to 144 parts by weight, and the content of the solvent was changed to 118 parts by weight of methyl ethyl ketone (MEK) as shown in the following Table 1.

[Table 1]

| | Type | Product | Example 1 | Example 2 | Example 3 | Example 4 | Example 5 | Example 6 | Comparative Example 1 | Comparative Example 2 | Comparative Example 3 | Comparative Example 4 | Comparative Example 5 |
|---|---|---|---|---|---|---|---|---|---|---|---|---|---|
| Curable resin | Bisphenol-based epoxy resin | YD-128 | 70 | 70 | 70 | 70 | 70 | 70 | 70 | 70 | 70 | 70 | 70 |
| | Phenol novolac type epoxy resin | YDPN-639 | 30 | 30 | 30 | 30 | 30 | 30 | 30 | 30 | 30 | 30 | 30 |
| Curing agent | Phenol resin | GPH-65 | 24 | 24 | 48 | 24 | 12 | 12 | 24 | 24 | 24 | 108 | - |
| | Cyanate ester resin | C03CS | 112 | 112 | 84 | 112 | 125 | 125 | 112 | 112 | 112 | - | 144 |
| | Styrene-maleic anhydride copolymer (SMA) | NST-438 | 14.0 | 41.8 | 31.5 | - | - | 14.0 | - | 14.0 | 14.0 | 14.0 | 14.0 |
| | | NST-414 | - | - | - | 8.40 | 15.75 | - | - | - | - | - | - |
| Inorganic filler | Silica (particle diameter) | K180SX-CM3 (0.18 μm) | 385 | 412 | 419 | 385 | 382 | - | 385 | - | - | 385 | 385 |
| | | SC2050-MB (0.5 μm) | - | - | - | - | - | - | - | 330 | - | - | - |
| | | Y100OSZ-CM3 (0.1μm) | - | - | - | - | - | 385 | - | - | - | - | - |
| | | Y5OSZ-CM3 (0.05μm) | - | - | - | - | - | - | - | - | 462 | - | - |
| | Solvent | MEK | 126 | 137 | 147 | 126 | 121 | 126 | 126 | 181 | 49 | 154 | 118 |
| Additive | Thermoplastic polymer resin (phenoxy resin) | YP-50 | 15 | 15 | 21 | 18 | 14 | 15 | 23 | 15 | 15 | 15 | 15 |
| | Imidazole-based curing accelerator | 2PHZ-PW | 0.1 | 0.1 | 0.1 | 0.1 | 0.1 | 0.1 | 0.1 | 0.1 | 0.1 | 0.1 | 0.1 |
| | Inorganic metal-based curing accelerator | Co(AcAc)$_2$ | 0.05 | 0.05 | 0.05 | 0.05 | 0.05 | 0.05 | 0.05 | 0.05 | 0.05 | 0.05 | 0.05 |

Styrene-maleic anhydride copolymer NST-414 (a MEK solution containing 60% of non-volatile components, content of maleic anhydride is 19% by weight, Nanokor Co., Ltd.) Styrene-maleic anhydride copolymer NST-438 (a MEK solution containing 60% of non-volatile components, content of maleic anhydride is 11% by weight, Nanokor Co., Ltd.)

**<Experimental Examples>**

1. Preparation of sample: Preparation of insulating film

The thermosetting resin compositions prepared in Examples 1 to 6 and Comparative Examples 1 to 5 were used as coating solutions to coat support films (PET films) having a thickness of 38 $\mu$m using an applicator, and then the support films were dried at 100°C for 8 minutes to prepare insulating film samples having a thickness of 25 $\mu$m.

**2. Experimental Example 1: Measurement of permittivity (Dk and Df)**

After the insulating film samples were each thermally cured at a temperature of 190°C for 90 minutes, the dielectric constant (Dk) and dielectric loss (Df) were measured at 10 GHz using a SPDR (split post dielectric resonator). The measurement results are shown in the following Table 2.

**3. Experimental example 2: Measurement of coefficient of thermal expansion (CTE)**

After the insulating film samples were each thermally cured at 190°C for 90 minutes, the coefficients of thermal expansion were measured in a range of 25°C to 120°C at a heating rate of 10°C/min using a TMA (TMA Q400 manufactured by TA Instruments). The measurement results are shown in the following Table 2.

**4. Experimental Examples 3 and 4: Evaluation of High Temperature Reliability**

1) Desmear treatment

The insulation film sample was compressed and laminated on a copper clad laminate (CCL) substrate under conditions of a temperature of 100°C and a pressure of 0.7 MPa for 30 seconds using a vacuum pressure laminator, and then pre-cured in a hot air oven at 100°C for 30 minutes, and then at 170°C for 30 minutes.
Subsequently, the support film (PET film) of the insulation film was peeled off to expose the insulation layer, and then desmear treatment was performed. The desmear treatment was performed in the order of swelling solution treatment (60°C, 5 minutes) - oxidation solution treatment (80°C, 20 minutes) - neutralization solution treatment (50°C, 4 minutes) using Securiganth MV series treatment solutions manufactured by Atotech.

**2) Measurement of surface roughness (Ra, nm) (Experimental Example 3)**

The surface of the desmeared insulation layer was measured five times per sample using an optical profiler (Nanoview 3D surface profiler NV-2700, Nanosystem), and the arithmetic mean roughness (Ra) was determined from the average value.

**3) Copper plating treatment**

Copper plating was performed in two stages of electroless chemical copper plating and electrolytic copper plating. Electroless chemical copper plating was performed using a Printoganth MV product manufactured by Atotech, such that the plating thickness was 1.0 $\mu$m, and after treatment, the sample was dried in a hot air oven at 150°C for 30 minutes.
Electrolytic copper plating was performed using an Expt Inpro SAP6 chemical manufactured by Atotech, such that the plating thickness was about 20 $\mu$m, and after treatment, the sample was heat-treated in a hot air oven set to a temperature of 190°C for 1 hour.

**4) Evaluation of high temperature reliability**

The high temperature reliability of the copper plated samples was evaluated using a Hot Air Reflow Test Machine (SEF Corporation). The test conditions were a maximum temperature of 260°C, a line speed of 20 cm/min, a line length of 100 cm, and a one pass time of 5 minutes, and after passing each sample 10 times, the appearance and copper foil adhesion were confirmed to determine the high temperature reliability.

**5) Evaluation of high temperature reliability (Experimental Example 4)**

The 90 degree peel strength of the copper plating layer was measured using a Texture Analyzer (TA-XT Plus) manufactured by Stable Micro Systems. The high temperature reliability was determined as the difference between the initial copper foil adhesion (A1 = adhesion measured after copper plating) and the final copper foil adhesion (A2) described in the above evaluation of high temperature reliability.

Measurements were made before and after the evaluation of high temperature reliability to evaluate the high temperature reliability, and then when the copper foil adhesion was reduced by 25% or more, it was determined that the copper foil adhesion was poor. In other words, when the following equation is not satisfied, it is determined as poor.

$$A2/A1 > 0.75 - Equation\ 1$$

In Equation 1,

A1 is initial copper foil adhesion (gf/cm) measured after copper plating on at least one surface of the insulating film, and A2 is final copper foil adhesion (gf/cm) measured after the insulating film was allowed to pass through a Hot Air Reflow Test Machine (SEF) 10 times under the following conditions: a maximum temperature of 260°C, a line speed of 20 cm/min, a line length of 100 cm, and a one pass time of 5 minutes.

Additionally, when the initial copper foil adhesion was less than 400 gf/cm, it was determined to be poor and the evaluation of high temperature reliability was not performed.

Further, after the evaluation of high temperature reliability, the appearance was confirmed, and when any appearance defects such as blister generation or copper foil lifting occurred, the high temperature reliability was determined to be poor. The determination results are shown in the following Table 2.

[Table 2]

| Type of thermosettin g resin composition | Experimenta 1 Example 1 | | Experimenta 1 Example 2 | Experimenta 1 Example 3 | Experimental Example 4 | |
|---|---|---|---|---|---|---|
| | Dk | Df | CTE | Surface roughness | Appearanc e | Copper foil |
| used in insulating film | | | | (nm) | | adhesio n |
| Example 1 | 3.1 | 0.012 | 37 | 264 | Good | Good |
| Example 2 | 3.1 | 0.011 | 36 | 242 | Good | Good |
| Example 3 | 3.1 | 0.014 | 40 | 166 | Good | Good |
| Example 4 | 3.1 | 0.011 | 37 | 247 | Good | Good |
| Example 5 | 3.1 | 0.010 | 35 | 239 | Good | Good |
| Example 6 | 3.2 | 0.014 | 39 | 162 | Good | Good |
| Comparative Example 1 | 3.2 | 0.012 | 38 | 280 | Poor | Poor |
| Comparative Example 2 | 3.1 | 0.011 | 35 | 892 | Good | Good |
| Comparative Example 3 | 3.2 | 0.016 | 44 | 111 | Poor | Poor |
| Comparative Example 4 | 3.2 | 0.019 | 52 | 153 | Good | Poor |
| Comparative Example 5 | 3.1 | 0.009 | 34 | 121 | Good | Poor |

According to Table 2 above, in the case of Examples 1 to 6, a low dielectric constant (Dk) of 3.5 or less, a low dielectric loss (Df) of 0.015 or less, and a low coefficient of thermal expansion (CTE) of 40 ppm/°C or less were exhibited, a surface roughness of 100 nm or more and 300 nm or less was exhibited, and copper foil adhesion was excellent, so that high temperature reliability was also good. In contrast, in the case of Comparative Example 1, the insulating film using a composition that does not use a styrene-maleic anhydride copolymer (SMA) showed a low dielectric loss and a low coefficient of thermal expansion, but as a result of the evaluation of high temperature reliability, many blisters were generated and the copper foil adhesion was reduced by 25% or more compared to the initial stage, indicating poor high temperature reliability.

Furthermore, in the case of Comparative Example 2, the particle diameter of silica was higher than the upper limit of the present invention, and the dielectric loss was low, the coefficient of thermal expansion was low, and copper foil adhesion was good, but the surface roughness after desmearing was 892 nm, which was very high compared to Examples 1 to 6, so that it was difficult for Comparative Example 2 to be applied to micro pattern applications.

In Comparative Example 3, the average particle diameter of silica was lower than the lower limit of the present invention, and as a result, the dielectric loss exceeded 0.015, the coefficient of thermal expansion exceeded 40 ppm/°C, and the appearance and copper foil adhesion were poor in the evaluation of high temperature reliability.

In Comparative Example 4, a cyanate ester resin was not used in a curing agent, and as a result, the coefficient of thermal expansion exceeded 40 ppm/°C, which was the highest, and the copper foil adhesion was poor in the evaluation of high temperature reliability.

Comparative Example 5 is a composition in which a phenolic resin is not used, had the lowest dielectric loss (Df) and coefficient of thermal expansion, but had poor copper foil adhesion in the evaluation of high temperature reliability.

## Claims

1. A thermosetting resin composition comprising a curable resin, a curing agent, a styrene-maleic anhydride copolymer SMA, and an inorganic filler,

    wherein the curable resin comprises an epoxy resin, the curing agent comprises a cyanate ester resin and a phenol resin, and
    the inorganic filler comprises a silica having an average particle diameter of 0.1 $\mu$m or more and less than 0.2 $\mu$m.

2. The thermosetting resin composition of claim 1, wherein the styrene-maleic anhydride copolymer comprises 10% or more and 40% or less of maleic anhydride.

3. The thermosetting resin composition of claim 1, wherein a content of the styrene-maleic anhydride copolymer is 5 parts by weight or more and less than 40 parts by weight with respect to 100 parts by weight of the cyanate ester resin.

4. The thermosetting resin composition of claim 1, wherein a weight ratio between the cyanate ester resin and the phenol resin is 95:5 to 40:60.

5. The thermosetting resin composition of claim 1, wherein a weight ratio between the epoxy resin and the cyanate ester resin is 60:40 to 20:80.

6. The thermosetting resin composition of claim 1, further comprising an additive,
    wherein the additive is selected from the group consisting of a curing accelerator, a leveling agent, a wetting agent, an antistatic agent, a thermoplastic polymer resin, and an antioxidant.

7. An insulating film comprising the thermosetting resin composition according to any one of claims 1 to 6.

8. The insulating film of claim 7, wherein the insulating film in a cured state under a condition of 10 GHz has a coefficient of thermal expansion CTE of 45 ppm/°C or less.

9. The insulating film of claim 7, wherein the insulating film in a cured state under a condition of 10 GHz has a dielectric constant Dk value of 3.5 or less, and a dissipation factor Df value of 0.015 or less.

10. The insulating film of claim 7, wherein a difference in copper foil adhesion satisfies the following Equation 1:

$$A2/A1 > 0.75 - \text{Equation 1}$$

    in Equation 1,
    A1 is the initial copper foil adhesion in gf/cm measured after copper plating on at least one surface of the insulating film, and A2 is the final copper foil adhesion in gf/cm measured after a hot air reflow test performed 10 times at a maximum temperature of 260°C on the insulating film.

11. A printed circuit board comprising the insulating film according to claim 7.

## INTERNATIONAL SEARCH REPORT

| International application No. |
| --- |
| **PCT/KR2024/015938** |

| A. | CLASSIFICATION OF SUBJECT MATTER |
| --- | --- |

**C08L 63/00**(2006.01)i; **C08G 59/40**(2006.01)i; **C08G 59/62**(2006.01)i; **C08L 35/06**(2006.01)i; **C08K 3/36**(2006.01)i; **C08J 5/18**(2006.01)i; **H05K 1/03**(2006.01)i

According to International Patent Classification (IPC) or to both national classification and IPC

| B. | FIELDS SEARCHED |
| --- | --- |

Minimum documentation searched (classification system followed by classification symbols)

C08L 63/00(2006.01); C08G 59/42(2006.01); C08G 59/44(2006.01); C08G 59/62(2006.01); C08J 5/18(2006.01); C08K 3/013(2018.01); C08K 9/06(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 에폭시(epoxy), 수지(resin), 실리카(silica), 페놀(phenol), 경화제(hardener)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2011-0054072 A (SEKISUI CHEMICAL CO., LTD.) 24 May 2011 (2011-05-24)<br>See claims 1-10; and paragraphs [0046]-[0235]. | 1-11 |
| Y | KR 10-1730283 B1 (SHENGYI TECHNOLOGY CO., LTD.) 25 April 2017 (2017-04-25)<br>See claim 1; and paragraphs [0011]-[0133]. | 1-11 |
| A | KR 10-2010-0095378 A (AJINOMOTO CO., INC.) 30 August 2010 (2010-08-30)<br>See claims 1-7. | 1-11 |
| A | KR 10-2243350 B1 (JNC CORPORATION) 21 April 2021 (2021-04-21)<br>See claim 1. | 1-11 |
| A | KR 10-2051374 B1 (SAMSUNG ELECTRONICS CO., LTD.) 08 January 2020 (2020-01-08)<br>See claims 1-17. | 1-11 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **12 February 2025** | **12 February 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

EP 4 696 744 A1

## INTERNATIONAL SEARCH REPORT
### Information on patent family members

International application No.

**PCT/KR2024/015938**

| Patent document cited in search report | | | Publication date (day/month/year) | Patent family member(s) | | | Publication date (day/month/year) |
|---|---|---|---|---|---|---|---|
| KR | 10-2011-0054072 | A | 24 May 2011 | CN | 102159616 | A | 17 August 2011 |
| | | | | CN | 102159616 | B | 06 August 2014 |
| | | | | JP | 2012-035452 | A1 | 16 February 2012 |
| | | | | JP | 4686750 | B2 | 25 May 2011 |
| | | | | KR | 10-1051873 | B1 | 25 July 2011 |
| | | | | US | 2011-0244183 | A1 | 06 October 2011 |
| | | | | WO | 2010-035452 | A1 | 01 April 2010 |
| KR | 10-1730283 | B1 | 25 April 2017 | EP | 2915848 | A1 | 09 September 2015 |
| | | | | EP | 2915848 | B1 | 30 May 2018 |
| | | | | KR | 10-2015-0081441 | A | 14 July 2015 |
| | | | | WO | 2014-067082 | A1 | 08 May 2014 |
| KR | 10-2010-0095378 | A | 30 August 2010 | JP | 2010-285594 | A | 24 December 2010 |
| | | | | JP | 5556222 | B2 | 23 July 2014 |
| | | | | KR | 10-1681512 | B1 | 01 December 2016 |
| KR | 10-2243350 | B1 | 21 April 2021 | CN | 104804638 | A | 29 July 2015 |
| | | | | CN | 104804638 | B | 28 September 2018 |
| | | | | JP | 2015-163685 | A | 10 September 2015 |
| | | | | JP | 6519183 | B2 | 29 May 2019 |
| | | | | KR | 10-2015-0089919 | A | 05 August 2015 |
| KR | 10-2051374 | B1 | 08 January 2020 | KR | 10-2019-0129655 | A | 20 November 2019 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230171426

- KR 1020240143082